(19) **Europäisches Patentamt**
**European Patent Office**
**Office européen des brevets**

(11) **EP 1 645 031 B1**

(12) **FASCICULE DE BREVET EUROPEEN**

(45) Date de publication et mention
de la délivrance du brevet:
**04.02.2009 Bulletin 2009/06**

(51) Int Cl.:
***H03H 7/06*** (2006.01)

(21) Numéro de dépôt: **04767868.5**

(22) Date de dépôt: **02.07.2004**

(86) Numéro de dépôt international:
**PCT/FR2004/050306**

(87) Numéro de publication internationale:
**WO 2005/006546 (20.01.2005 Gazette 2005/03)**

(54) **FILTRE PASSE BAS POUR FILTRAGE DE SIGNAUX ADSL SUR DES LIGNES TELEPHONIQUES**

TIEFPASSFILTER ZUR FILTERUNG VON ADSL-SIGNALEN AUF TELEFONLEITUNGEN

LOW-PASS FILTER FOR THE FILTERING OF ADSL SIGNALS ON TELEPHONE LINES

(84) Etats contractants désignés:
**AT BE BG CH CY CZ DE DK EE ES FI FR GB GR
HU IE IT LI LU MC NL PL PT RO SE SI SK TR**

(30) Priorité: **03.07.2003 FR 0350291**

(43) Date de publication de la demande:
**12.04.2006 Bulletin 2006/15**

(73) Titulaire: **Laboratoire Europeen ADSL Leacom
Fastnet
35510 Cesson Sevigne (FR)**

(72) Inventeur: **DEDIEU, Hervé
F-35500 Vitre (FR)**

(74) Mandataire: **Camus, Olivier Jean-Claude et al
SCHMIT CHRETIEN
8, place du Ponceau
95000 Cergy (FR)**

(56) Documents cités:
**EP-A- 0 677 938       WO-A-01/06737
FR-A- 2 823 627       US-B1- 6 559 808**

**Description**

La présente invention a pour objet un dispositif de filtrage passe-bas intervenant dans le découplage des voies ADSL. Elle est destinée à être incorporée dans un dispositif séparateur de signaux voix-données pour une transmission sur des voies ADSL. Elle propose une réalisation particulière de filtres, dont les performances sont comparables à celles des filtres elliptiques, et dont l'encombrement est moins important que celui imposé par la structure desdits filtres elliptiques.

Le dispositif de filtrage selon l'invention est destiné à être utilisé du côté abonné ou dans des centraux téléphoniques, qui sont des points de répartition et de regroupement des communications téléphoniques et des données transmises selon la technologie ADSL.

Le domaine de l'invention est, d'une façon générale, celui de la technologie dite ADSL (pour Asymmetric Digital Subscriber Line, en anglais, pour ligne d'abonné numérique à débit asymétrique), elle s'appliquera de même aux autres technologies DSL qui requièrent une séparation voix-données. Cette technologie est essentiellement mise en oeuvre sur des boucles locales des réseaux de téléphonie existant, la boucle locale étant constituée par les intermédiaires du réseau entre un central téléphonique et un poste d'abonné. Un des objectifs essentiels de cette technologie est de rendre possible, sur les boucles locales des anciens réseaux de téléphonie, la transmission simultanée de différents types de signaux : d'une part, les signaux relatifs aux conversations téléphoniques habituelles entre deux abonnés, ces premiers signaux comprenant des signaux relatifs à la voix et des signaux de signalisation, et d'autre part, des signaux relatifs à des données, typiquement des informations échangées entre un abonné et un site accessible via le réseau Internet.

Pour des transmissions selon cette technologie, on utilise donc la paire de fils de cuivre qui arrive chez l'abonné, et qui constitue depuis longtemps la ligne téléphonique, ou boucle d'abonné, à laquelle sont raccordés les différents combinés téléphoniques de l'utilisateur des réseaux analogiques traditionnels dits POTS (pour Plain Old Transmission System - système ancien de télécommunications) ou des réseaux numériques traditionnels dits ISDN (ou RNIS - réseau numérique à intégration de services). Cette paire de fils de cuivre est le plus souvent torsadée et comporte une gaine isolante en polyéthylène.

Sur cette paire de fils de cuivre, on transmet donc à la fois :

- en bande de base, des signaux analogiques non modulés correspondant aux réseaux POTS, ou des signaux numériques correspondant aux réseaux ISDN. Les signaux analogiques en bande de base sont de fréquence typiquement 0 à 4 kHz, ou 0 à 16 KHz si on tient compte des signaux de signalisation. Les signaux numériques ISDN en bande de base sont dans des fréquences de 0 à 94 KHz. En pratique, la bande de base est destinée à une transmission en mode circuit;

- en bande haute fréquence, d'autres signaux, numériques et modulés, qui correspondent par exemple aux informations échangées avec le réseau Internet. La bande haute s'étale du dessus de la bande de base téléphonique jusqu'à 1 MHz environ. En pratique la bande haute fréquence s'étale de 32 KHz à 1,1 MHz si la paire de fils de cuivre sert en bande de base pour une transmission analogique POTS, et de 138 KHz à 1,1 MHz si elle sert pour une transmission numérique. Elle est normalement destinée à une transmission permanente, en mode paquets principalement, c'est à dire qu'une communication permanente est établie entre l'abonné et le central téléphonique. On est ainsi dispensé des opérations classiques intervenant lors d'une connexion avec accès par ligne commutée, qui est une méthode de connexion temporaire à un réseau informatique consistant à utiliser un modem, un logiciel de connexion et le réseau téléphonique commuté comme moyen de mise en communication de son propre ordinateur et d'un autre ordinateur du réseau.

Bien que la bande de base puisse être utilisée, notamment avec des modems de préférence numériques, pour transmettre des données, et que la bande haute fréquence puisse servir à assurer des communications phoniques dans le cadre de communications dites communications téléphoniques sur Internet, on considérera, de façon schématique, et dans un souci de simplification des explications, que la bande de base est utilisée pour la transmission d'un premier type de signaux, essentiellement des paroles, correspondant à des communications phoniques, et que la bande haute fréquence sert pour la transmission d'un deuxième type de signaux, essentiellement des données, relatives notamment à la consultation de sites Internet.

La bande de base n'est capable que d'un faible débit (actuellement 56 Kbits/s pour les modems analogiques et 64 Kbits/s pour les modems numériques) alors que la bande haute fréquence est susceptible de présenter un haut débit (pouvant avoisiner 10 Mbits/s).

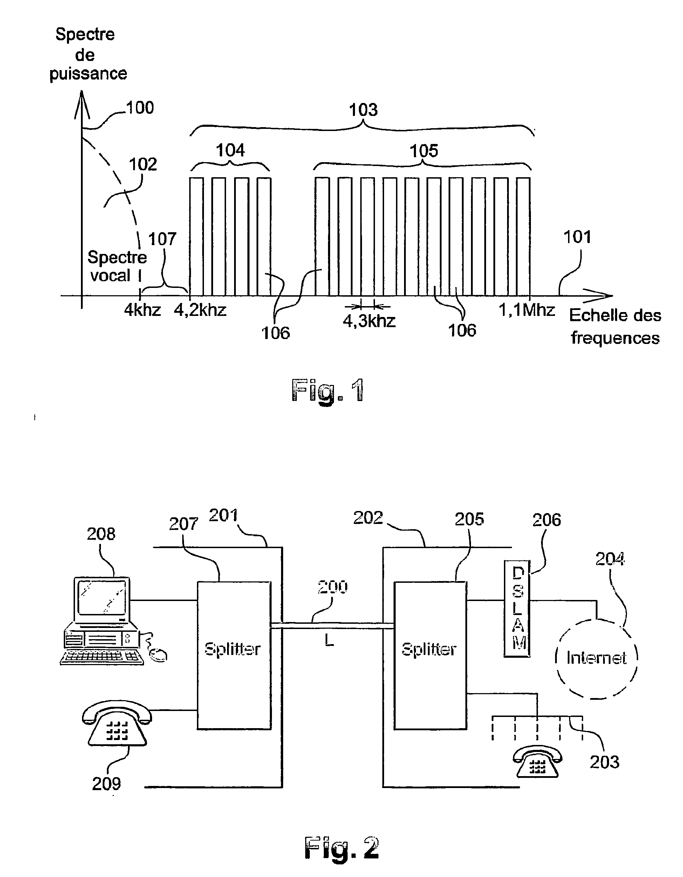

La figure 1 illustre l'exploitation de la bande de fréquence en distribution ADSL. L'axe des ordonnées 100 échelonne la puissance des signaux émis, et l'axe des abscisses 101 donne l'échelle des fréquences. Les puissances émises sont représentées de façon équirépartie dans un but de simplification. On retrouve le spectre vocal 102 s'étendant de 0 à 4 kHz, et le spectre 103 utilisé pour la transmission de données selon la technologie ADSL, ce dernier s'étendant d'environ 30 kHz à 1,1 MHz. Le spectre 103 est divisé en deux parties principales : une première bande de fréquence 104 correspondant au spectre utilisé pour les données montantes (de l'abonné vers le central) et une deuxième bande de fréquence 105 correspondant au spectre utilisé pour les données descendantes (du central vers l'abonné).

L'utilisation d'une ligne dite ADSL nécessite donc de séparer la bande de base, basse fréquence, de la bande haute fréquence. La figure 2 illustre schématiquement ces séparations au niveau d'une boucle locale de communication. Sur cette figure, on a représenté une ligne téléphonique usuelle 200, ou ligne de transmission, ou boucle d'abonné, composée de deux fils en cuivre, qui assure la liaison entre un abonné 201, qui dispose d'une installation privative, et un central téléphonique 202.

Le central téléphonique 202 assure la connexion à un réseau de téléphonie classique 203, appelé POTS, et à un réseau de type Internet 204. Afin de dissocier les signaux destinés au réseau téléphonique 203 et au réseau Internet 204, un premier dispositif 205 séparateur de signaux voix-données, également appelé filtre à aiguillage ou splitter, est utilisé. D'une façon générale, un splitter est un dispositif électronique associé à un modem ADSL qui permet de séparer les signaux de la voix des signaux de données et de les acheminer sur deux voies différentes. Le splitter 205 sera désigné par la suite comme splitter central. Les données destinées au - ou provenant du - réseau Internet 204 transitent par un multiplexeur d'accès DSL 206, appelé DSLAM (pour Digital Subscriber Line Access Multiplexer en anglais), qui est relié au splitter central 205.

Du côté de l'abonné 201, on trouve également un splitter 207 relié à la ligne téléphonique 200. Le splitter 207 est appelé splitter maître. Le splitter maître 207 a pour fonction de séparer, côté abonné, les signaux de données, qui sont orientés vers un ordinateur personnel 208 associé à un modem ADSL, et les signaux de voix, qui sont orientés vers des combinés téléphoniques classiques 209. Chaque téléphone 209 connecté à la même ligne 200 doit être protégé par un filtre passe-bas contenu dans le splitter 207. La compacité de ces filtres les a consacrés sous l'appellation micro-filtres.

En théorie, on trouve également, dans chaque splitter 205 et 207, un filtre haute fréquence, qui laisse passer uniquement les signaux ADSL. Dans la pratique, le filtre basse fréquence et le filtre haute fréquence des splitters sont séparés et distincts. Le filtre haute fréquence, c'est à dire le filtre qui laisse passer les signaux de données et uniquement ceux-là, est disposé, côté central téléphonique dans le DSLAM 206, et côté abonné dans un modem connecté à l'ordinateur 208. Les filtres basse fréquence sont, pour leur part, intégrés dans les splitters 205 et 207. Chaque filtre basse fréquence sert à empêcher que des signaux phoniques ne soient perturbés par des signaux de données. L'objet de l'invention est la réalisation d'un tel filtre, présentant une bande de transition très étroite tout en étant peu encombrant.

L'installation des filtres, et notamment des filtres passe-bas, doit satisfaire à plusieurs contraintes dictées par différentes normes :

- le respect de valeurs d'impédances d'entrée et de sortie imposées. Afin que la puissance transmise par la ligne téléphonique le soit avec le meilleur rendement possible, les lignes téléphoniques doivent être terminées, en entrée et en sortie, par une impédance ayant une valeur aussi proche que possible de l'impédance caractéristique de la ligne téléphonique.

- le facteur dit d'affaiblissement d'insertion, ou ILF (pour Insertion Loss Factor en anglais), qui mesure un affaiblissement de puissance d'une voie de transmission lorsqu'il s'y trouve des montages en pont, des filtres, des égaliseurs ou d'autres montages. Dans le cas présent, ce facteur mesure la perte de transmission occasionnée dans le circuit par la mise en place d'un filtre, entre une situation où le filtre n'est pas présent et une situation où il est mis en place.

- le facteur dit d'affaiblissement de réflexion, ou RLF (pour Return Loss en anglais), qui est une mesure liée à la puissance de signal réfléchi par rapport à la puissance de signal transmissible. Lorsque l'adaptation est parfaite, le Return Loss tend vers l'infini.

- le facteur dit d'atténuation en bande ADSL, qui détermine une perte de puissance à faire subir aux signaux dont la fréquence appartient aux fréquences ADSL ;

- le facteur dit de distorsion d'insertion (insertion distortion en anglais), qui impose un variation maximale du facteur d'affaiblissement d'insertion.

Pour tenter de satisfaire à toutes ces contraintes, il a été imaginé différents types de filtres basse fréquence. Une des solutions préférées de l'état de la technique, pour la réalisation de filtres passe-bas destinés à être disposés sur des lignes téléphoniques, est l'utilisation de filtres elliptiques, également appelés filtres de Cauer, connus de l'homme du métier.

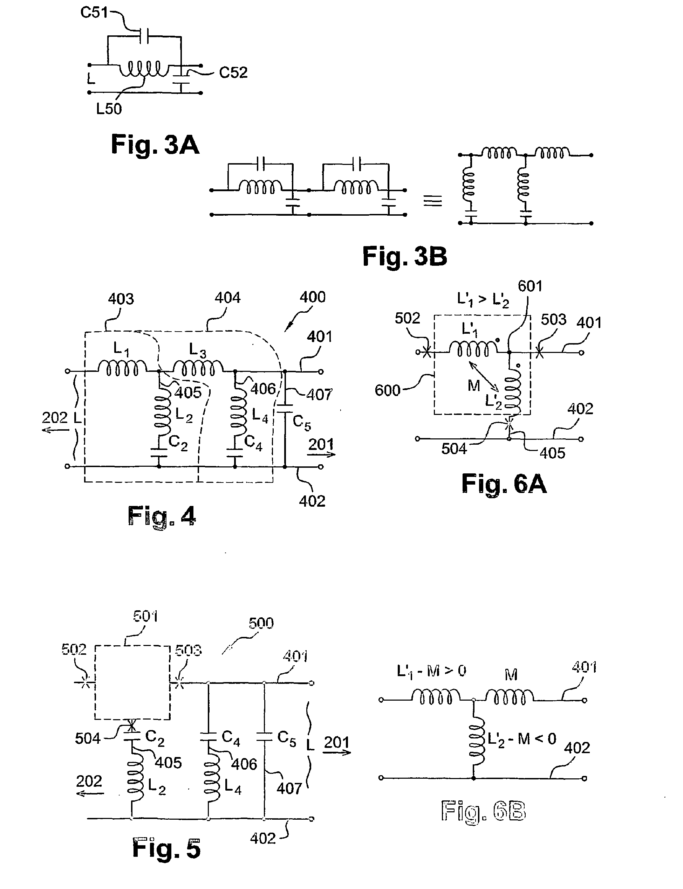

Ces filtres sont constitués d'une succession de cellules elliptiques, dont la structure de base est représentée figure 3a. Un des brins de la ligne téléphonique L comporte, montées en parallèle, une inductance L50 et une première capacité C51 qui constituent un circuit anti-résonant. Une deuxième capacité C52 est disposée entre les deux brins de la ligne L. Dans la pratique, cette cellule de base est équilibrée de façon à respecter les normes de la téléphonie. La partie gauche de la figure 3-b montre un circuit électronique correspondant à une réalisation de la cellule elliptique répétée en cascade, et la partie droite de la figure 5-b montre la forme duale de ce circuit électronique. De tels filtres ont notamment comme caractéristique de pouvoir présenter, en choisissant des valeurs de composants appropriées, un important taux de réjection entre les signaux dont les fréquences appartiennent à la bande des signaux phoniques et les signaux dont les fréquences appartiennent à la bande des signaux ADSL.

Cependant, de telles structures de filtres ne sont pas entièrement satisfaisantes en pratique d'un point de vue économique. En effet, les exigences des différentes normes en terme de niveau de réjection des signaux ADSL et de return loss impliquent la présence d'au moins deux cellules elliptiques en cascade, et donc un nombre important d'inductances, au sein du filtre basse fréquence. Ceci a pour conséquence d'une part un coût non négligeable dans la réalisation des filtres, et, d'autre part, un espace occupé par chaque splitter de l'ordre de 15 à 20 cm$^2$. Cet encombrement n'est pas négligeable, essentiellement du côté central téléphonique où de nombreux splitters sont montés ensemble sur une même carte.

Un des objets essentiels de l'invention est de proposer un filtre passe-bas qui s'affranchit des inconvénients qui viennent d'être exposés. A cet effet, le filtre passe-bas selon l'invention est un circuit électronique dans lequel on propose de coupler, au sein d'un autotransformateur, différentes inductances présentes dans les formes duales des cellules elliptiques en cascade, et notamment dans les formes non équilibrées de ce circuit électronique, tout en compensant une inductance négative induite par ce couplage d'inductances. Dans certains modes de réalisation de l'invention, la compensation de ce couplage prend la forme d'un circuit actif émulant les caractéristiques d'une inductance dont la valeur est suffisamment élevée pour compenser l'inductance négative induite.

L'invention concerne donc essentiellement un dispositif de filtrage passe-bas disposé sur une ligne de transmission téléphonique composée d'un premier brin et d'un deuxième brin, susceptible de faire circuler simultanément, entre un central téléphonique et un abonné équipé d'au moins un téléphone, des premiers signaux correspondant à des services bande étroite analogique et/ou numérique, et des seconds signaux correspondant à des services large bande caractérisé en ce que une forme non équilibrée du dispositif de filtrage comporte :

- un autotransformateur, constitué d'un enroulement d'une première inductance et d'un enroulement d'une deuxième inductance, bobinées autour d'un unique noyau magnétique, disposé entre un premier point d'entrée sur le premier brin de la ligne de transmission, un deuxième point d'entrée sur le premier brin de la ligne de transmission, et un troisième point d'entrée sur une première branche de dérivation reliant le premier brin et le deuxième brin;
- une première capacité disposée en série avec un troisième inductance sur la première branche de dérivation, la troisième inductance ayant une valeur au moins suffisante pour compenser une inductance négative induite par l'autotransformateur dans la première branche de dérivation.

L'ensemble du circuit électronique dans la branche de dérivation forme alors un circuit résonant.

Outre les caractéristiques principales qui viennent d'être mentionnées, le dispositif de filtrage selon l'invention peut comporter une ou plusieurs caractéristiques supplémentaires parmi les suivantes :

- la troisième inductance est réalisée sous la forme d'un premier circuit actif.
- la première inductance est disposée sur le premier brin de la ligne de transmission, et la deuxième inductance est disposée sur la première branche de dérivation, la première inductance et la deuxième inductance pouvant alors être enroulées autour de l'unique noyau magnétique de façon à réaliser un couplage avec renforcement négatif des inductances mutuelles.
- la première inductance et la deuxième inductance sont disposées sur le même premier brin de la ligne de transmission, la première inductance et la deuxième inductance pouvant alors être enroulées autour de l'unique noyau magnétique de façon à réaliser un couplage avec renforcement positif des inductances mutuelles. Cette caractéristique permet une réalisation du filtre passe-bas selon l'invention dans lequel un nombre plus faible de spires est nécessaire pour réaliser les inductances
- le dispositif de filtrage comporte :

  - une deuxième capacité, en série avec une quatrième inductance, disposés sur une deuxième branche de dérivation reliant le premier brin, au niveau du deuxième point d'entrée de l'autotransformateur, et le deuxième brin de la ligne de transmission ; ce circuit résonnant excédentaire crée alors un deuxième pôle de transmission;
  - une troisième capacité disposée sur une troisième banche de dérivation reliant le premier brin de la ligne de transmission, au niveau du deuxième point d'entrée de l'autotransformateur, au deuxième brin de la ligne de transmission.
  - la quatrième inductance est réalisée sous la forme d'un deuxième circuit actif ou passif.
  - le dispositif de filtrage peut être disposé du côté abonné ou du côté central téléphonique.

Un autre objet de l'invention est la forme équilibrée du dispositif de filtrage passe bas présentant les caractéristiques principales et éventuellement une ou plusieurs caractéristiques supplémentaires qui viennent d'être mentionnées.

L'invention et ses différentes applications seront mieux comprises à la lecture de la description qui suit et à l'examen des figures qui l'accompagnent. Celles-ci ne sont présentées qu'à titre indicatif et nullement limitatif de l'invention. Les figures montrent :

- à la figure 1, déjà décrite, une représentation de l'exploitation de la bande de fréquence en distribution ADSL ;
- à la figure 2, déjà décrite, une illustration du principe de la séparation des signaux basse fréquence et haute fréquence sur une ligne ADSL ;

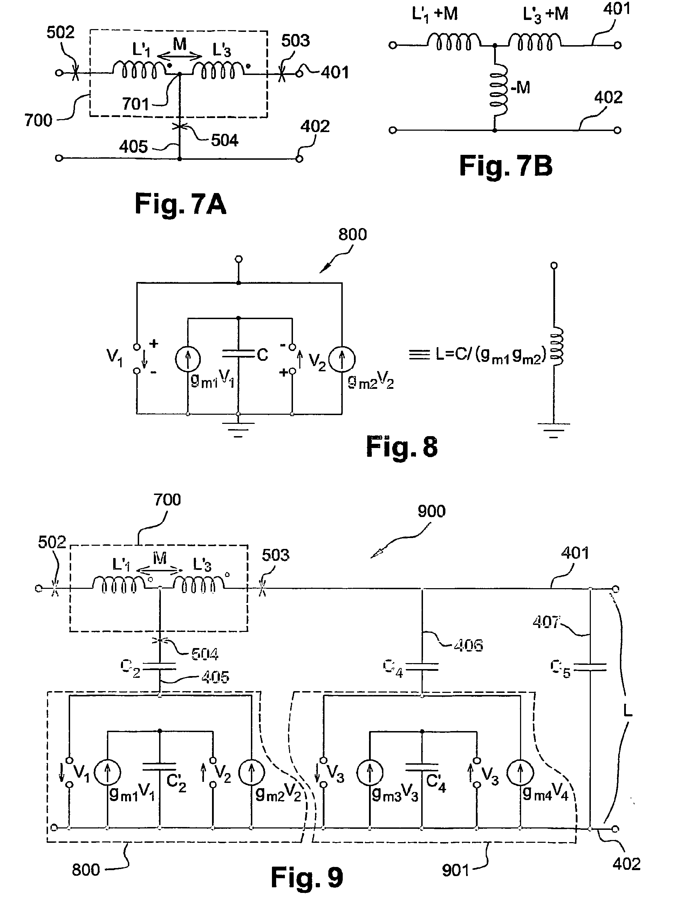

- aux figures 3-a et 3-b, déjà décrites, différentes représentations de cellules elliptiques,
- à la figure 4, un exemple de filtre passe-bas utilisé dans l'état de la technique ;
- à la figure 5, une représentation non équilibrée d'un filtre passe-bas selon l'invention intégré dans le circuit électronique de la figure 4. ;
- aux figures 6-a et 6-b, un premier exemple de réalisation d'un autotransformateur intervenant dans les filtres passe-bas selon l'invention et un circuit électronique équivalent à cet autotransformateur;
- aux figures 7-a et 7-b, un deuxième exemple de réalisation d'un autotransformateur intervenant dans les filtres passe-bas selon l'invention et un circuit électronique équivalent à cet autotransformateur;
- à la figure 8, un exemple de réalisation d'un circuit actif susceptible d'intervenir dans le filtre passe-bas selon l'invention ;
- à la figure 9, une représentation non équilibrée d'une intégration d'un exemple de réalisation du filtre passe-bas selon l'invention dans un circuit électronique particulier ;

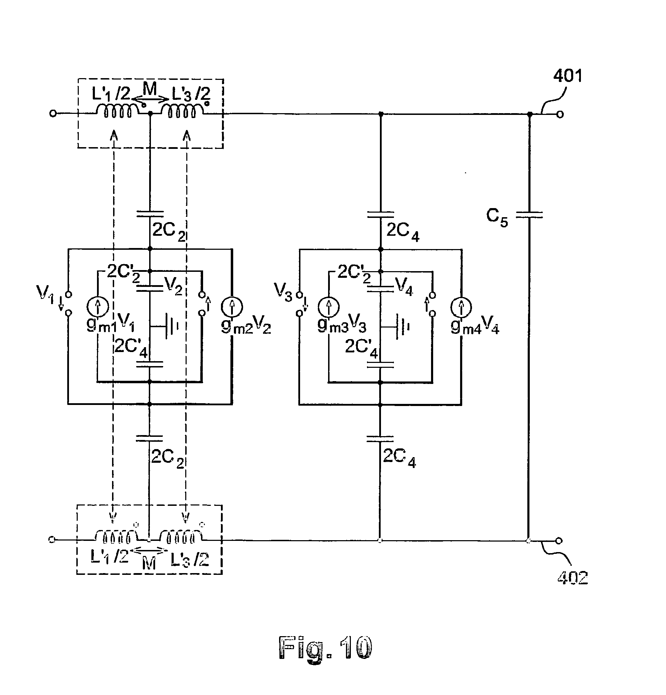

- à la figure 10, une représentation équilibrée de l'exemple de la figure 10.

Les éléments apparaissant sur différentes figures auront conservé les mêmes références.

La figure 4 représente un exemple d'architecture de filtre passe-bas 400 utilisé dans l'état de la technique pour le filtrage des signaux ADSL. L'architecture représentée correspond à la forme non équilibrée du filtre 400 ; une forme non équilibrée d'un filtre destiné à être disposé sur une ligne téléphonique est toujours associée a une forme équilibrée dans laquelle le filtre considéré est symétrisé ; notamment, chaque composant électronique présent sur un premier brin est alors présent sur le second brin de telle sorte que des parasites dits de mode commun affectent de la même manière les deux brins de ligne et puissent être éliminés de manière différentielle au récepteur. Les valeurs des composants d'une forme équilibrée, disposés le long des brins de la ligne, sont, en fonction de leur nature capacitive ou inductive, multipliées ou divisées par deux par rapport aux valeurs des composants correspondant de la forme non équilibrée. Les valeurs des composants disposés entre les deux brins restent inchangés lors du passage de la forme non équilibrée à la forme équilibrée.

Sur la figure 4, une ligne téléphonique classique L est composée d'un premier brin de ligne de transmission 401, appelée brin A ou ligne TIP, et d'un deuxième brin de ligne de transmission 402, appelée brin B ou ligne RING. La description de la figure représentant la structure du filtre s'effectue de gauche à droite, c'est à dire en partant, pour chaque ligne de transmission, du côté ligne (avec une entrée haute impédance pour les signaux DSL), aboutissant au central téléphonique 202, appelé côté POTS par l'homme de l'art (Plain Old Line Telephone System en Anglais). Il en sera de même pour les figures suivantes où la ligne téléphonique L apparaît.

Le filtre 400 est composé, dans leur forme duale, d'une première cellule elliptique 403 en cascade avec une deuxième cellule elliptique 404. La première cellule elliptique 403 est composée d'une première inductance L1 disposée sur le premier brin de la ligne de transmission 401, et d'une deuxième inductance L2 en série avec une première capacité C2 sur une première branche de dérivation 405 reliant le premier brin 401 et le deuxième brin 402. La deuxième cellule elliptique 404 est composée d'une troisième inductance L3 disposée sur le premier brin de la ligne de transmission 401, et d'une quatrième inductance L4 en série avec une deuxième capacité C4 sur une deuxième branche de dérivation 406 reliant le premier brin 401 et le deuxième brin 402 de la ligne de transmission. Une troisième branche de dérivation 407 complète le filtre 400 ; elle comporte une troisième capacité C5, essentiellement destinée à limiter les bruits en sortie du filtre 400.

Les différentes inductances présentes dans le filtre 400 sont associées à des noyaux magnétiques distincts. Un des objets essentiels de l'invention est de limiter, dans les filtres passe-bas utilisés dans le filtrage des signaux ADSL et dont le circuit 400 est un exemple, le nombres de noyaux magnétiques utilisés. Ainsi, dans l'invention, on propose l'utilisation d'autotransformateurs passifs qui permettent le regroupements de plusieurs inductances autour d'un même noyau magnétique. Ce principe général de l'invention est illustré à la figure 5, où un circuit électronique 500 est représenté. Le circuit électronique 500 correspond au filtre passe-bas 400 dans lequel le groupe constitué par les trois inductances L1, L2 et L3 a été remplacé par un auto-transformateur passif 501, dont différents modes de réalisations seront détaillés par la suite. L'autotransformateur 501 comporte trois points d'entrée : un premier point d'entrée 502 sur le premier brin de la ligne de transmission 401, un deuxième point d'entrée 503 également sur le premier brin de la ligne de transmission 401 et un troisième point d'entrée 504 sur la première branche de dérivation 405. Une inductance de compensation L''2 a été ajoutée dans la première branche de dérivation 405 pour compenser une inductance négative induite, générée par l'autotransformateur 501 comme il le sera expliqué dans la suite de la description.

Un premier exemple 600 d'autotransformateur passif est représenté à la figure 6-A. Sur cette figure, on voit que l'autotransformateur 600 est constitué de l'enroulement d'une première inductance L'1, disposée sur le premier brin 401, et d'une deuxième inductance L'2, disposée sur la première branche de dérivation 405, autour d'un même noyau magnétique. La première inductance L'1 est connectée entre le premier point d'entrée 502 et un point de liaison 601, situé sur le premier brin 401, et directement relié au deuxième point d'entrée 503. Le point de liaison 601 représente le point de connexion entre la première inductance L'1 et la deuxième inductance L'2 au sein de l'autotransformateur 600. La deuxième inductance L'2 est connectée entre le troisième point d'entrée 504 et le point de liaison 601.

Dans cet exemple, la première inductance L'1 et la deuxième inductance L'2 sont couplées avec un renforcement négatif des inductances mutuelles. Ainsi, si on considère que M est l'inductance mutuelle de l'auto-transformateur 600, un circuit équivalent au circuit de la figure 6-A, sans la présence d'inductance mutuelle, est représenté à la figure 6-B. Ce circuit comporte, comme représenté, une première inductance de valeur L'1-M et une deuxième inductance de valeur M sur le premier brin de la ligne de transmission 401, et une troisième inductance, dite inductance induite, de valeur L'2-M sur la première branche de dérivation 405. En comparant cette architecture à celle formée par les inductances L1, L2 et L3 de la figure 4, et en supposant un couplage parfait, on aboutit aisément aux équations suivantes :

$$M = L3 \qquad (1.1)$$

$$L'1 = L1 + L3 \qquad (1.2)$$

$$L'2 = L3^2/(L1+L3) \qquad (1.3)$$

Par ailleurs, dans le couplage réalisé entre L'1 et L'2, où L'1 est supérieur à L'2, on montre que l'inductance de valeur L'1-M est positive et que l'inductance induite de valeur L'2-M est négative. Ainsi, pour compenser cette valeur négative d'inductance induite, on introduit, dans le circuit selon l'invention, l'inductance L"2, visible notamment à la figure 5, qui, pour que le circuit de la figure 5 corresponde à celui de la figure 4, doit respecter l'équation suivante :

$$L''2 = L2 + L3 - L3^2/(L1+L3) \quad (1.4)$$

Un deuxième exemple 700 d'autotransformateur passif est représenté à la figure 7-A. Sur cette figure, on voit que l'autotransformateur 700 est constitué de l'enroulement d'une première inductance L'1, disposée sur le premier brin de la ligne de transmission 401, et d'une deuxième inductance L'3, également disposée sur le premier brin 401, autour d'un même noyau magnétique. La première inductance L'1 est connectée entre le premier point d'entrée 502 et un point de liaison 701, situé sur le premier brin de la ligne de transmission 401, et directement relié aU troisième point d'entrée 504. Comme dans le premier exemple représenté, le point de liaison 701 représente le point de connexion entre la première inductance L'1 et la deuxième inductance L'3 au sein de l'autotransformateur 700. La deuxième inductance L'3 est connectée entre le deuxième point d'entrée 503 et le point de liaison 701.

Dans cet exemple, la première inductance L'1 et la deuxième inductance L'3 sont couplées avec un renforcement positif des inductances mutuelles. Ainsi, si on considère que M est l'inductance mutuelle de l'auto-transformateur 700, un circuit équivalent au circuit de la figure 7-A, sans la présence d'inductance mutuelle, est représenté à la figure 7-B. Ce circuit comporte, comme représenté, une première inductance de valeur L'1+M et une deuxième inductance de valeur L'3+M sur le premier brin 401, et une troisième inductance, dite inductance induite, de valeur -M sur la première branche de dérivation 405. En comparant cette architecture à celle formée par les inductances L1, L2 et L3 de la figure 4, on aboutit aisément aux équations suivantes :

$$L'1 = L1^2/(L1+L3) \qquad (2.1)$$

$$L'3 = L3^2/(L1+L3) \qquad (2.2)$$

$$M = L1L3/(L1+L3) \qquad (2.3)$$

Par ailleurs, dans le couplage réalisé entre L'1 et L'3, l'inductance induite de valeur -M est négative. Ainsi, pour compenser cette valeur négative d'inductance induite, on introduit, dans le circuit selon l'invention, l'inductance L"2, visible notamment à la figure 5, qui, pour que le circuit de la figure 5 corresponde à celui de la figure 4, doit respecter l'équation suivante :

$$L''2 = L2 + L1L3/(L1+L3) \quad (2.4)$$

Ainsi, dans les filtres passe-bas selon l'invention, on propose, à la place d'une disposition en T de trois inductances attachées à trois noyaux magnétiques distincts, comme c'est le cas par exemple à la figure 4, la mise en place d'un autotransformateur passif 600 ou 700, composé de deux inductances enroulées autour d'un même noyau magnétique, réalisant un couplage avec renforcement positif ou négatif, selon les cas, des inductances mutuelles. On prévoit par ailleurs l'ajout d'une inductance de compensation pour au moins compenser une inductance induite négative générée dans une branche de dérivation par l'autotransformateur. En pratique l'inductance de compensation L"2 pourra être de petite dimension car la présence de la capacité C2 en série avec L"2 garantit que l'inductance n'est traversée par aucun courant continu

De plus, on prévoit avantageusement, dans les filtres passe-bas selon l'invention, de remplacer l'inductance de compensation L"2 par un circuit actif émulant cette capacité, ce circuit actif étant d'une conception simple car non traversé par le courant continu. Un tel circuit actif 800 est représenté sur la partie gauche de la figure 8. Cette réalisation est possible du fait de l'absence de courant continu dans la branche de dérivation 405 grâce à la présence d'une capacité dans cette branche.

Le circuit actif 800 comporte notamment deux amplificateurs opérationnels à transconductance, ou OTA (pour Operational Transonductance Amplifiers en anglais) qui sont des sources de courant contrôlées en tension, et qui transforment une tension Vi en un courant li d'intensité égale à gmiVi, où gmi est la transconductance de l'amplificateur considéré, et où i est un entier naturel. Un tel circuit permet de remplacer une inductance Li par un circuit actif intégrant une capacité Ci', le circuit actif pouvant ainsi facilement être réalisé sous la forme d'un ASIC. La relation entre la capacité Ci' présente dans le circuit actif 800 et l'inductance LI qu'il remplace est donné par l'équation :

$$Li = Ci'/(gm1\,gm2) \qquad (3.1)$$

La figure 9 montre un exemple particulier de réalisation, dans sa forme non équilibrée, d'un filtre passe-bas 900 selon l'invention. Avec des valeurs adéquates, un tel filtre présente les mêmes caractéristiques en terme de return loss, de rejection loss, et d'atténuation que le circuit plus encombrant de la figure 4. Le circuit 900 représenté correspond, à titre d'exemple uniquement, à l'utilisation de l'autotransformateur décrit à la figure 7-A ; l'autotransformateur décrit à la figure 6-A aurait également pu être utilisé. Dans l'exemple illustré, l'inductance L4 a été remplacé par un circuit actif 901 similaire au circuit actif 800, avec une capacité C4' égale à L4.(gm3.gm4), conformément à l'équation (3.1), et où gm3 et gm4 sont les deux transconductances des deux amplificateurs opérationnels à transconductance intervenant dans la réalisation du circuit actif 901.

Dans l'exemple illustré de réalisation de filtre passe bas selon l'invention, on adopte, pour satisfaire aux différentes contraintes de filtrage des signaux ADSL, les valeurs suivantes, à dix pour cent près, pour les différents composants de la forme non équilibrée:

L'1=5.97 mH

L'3= 15.4 mH

L"2= 9 8 mH

L4= 1.15 mH

C2= 68 nF

C4= 33 nF

C5= 1 n F

Dans l'exemple non représenté de réalisation de filtre passe bas selon l'invention, correspondant à l'utilisation de l'autotransformateur de la figure 6-A, on adopte, pour satisfaire aux différentes contraintes de filtrage des signaux ADSL, les valeurs suivantes, à dix pour cent près, pour les différents composants de la forme non équilibrée :

L'1= 40.5 mH
L'2= 15.4 mH
L"2= 9.8 mH
L4= 1.15 mH
C2= 68 nF
C4= 33 nF
C5= 1 nF

Pour la réalisation de la forme équilibrée, visible à la figure 10, du circuit représenté à la figure 9, ou pour la réalisation de la forme équilibrée du circuit similaire à celui de la figure 9 mais utilisant l'autotransformateur de la figure 6-A, les valeurs des différentes inductances sont, comme il l'a été précédemment évoqué, doublées et les valeurs des différentes capacités sont divisées par 2 par rapport aux deux jeux de valeur qui viennent d'être donnés.

## Revendications

1. Dispositif de filtrage passe-bas disposé sur une ligne de transmission téléphonique (L) composée d'un premier brin (401) et d'un deuxième brin (402), susceptible de faire circuler simultanément, entre un central téléphonique (202) et un abonné (201) équipé d'au moins un téléphone, des premiers signaux correspondant à des services bande étroite analogique et/ou numérique, et des seconds signaux correspondant à des services large bande **caractérisé en ce que** une forme non équilibrée du dispositif de filtrage (500) comporte :

   - un autotransformateur (501), constitué d'un enroulement d'une première inductance (L'1) et d'un enroulement d'une deuxième inductance (L'2 ; L'3), bobinées autour d'un unique noyau magnétique, disposé entre un premier point d'entrée (502) sur le premier brin de la ligne de transmission (401), un deuxième point d'entrée (503) sur le premier brin de la ligne de transmission (401), et un troisième point d'entrée (504) sur une première branche de dérivation (405) reliant le premier brin (401) et le deuxième brin (402) ;
   - une première capacité (C2) disposée en série avec une troisième inductance (L"2) sur la première branche de dérivation (405), la troisième inductance (L"2) ayant une valeur au moins suffisante pour compenser une inductance négative induite par l'autotransformateur (501) dans la première branche de dérivation (405).

2. Dispositif de filtrage selon la revendication précédente **caractérisé en ce que** la troisième inductance (L"2) est réalisée sous la forme d'une premier circuit actif (800).

3. Dispositif de filtrage selon l'une au moins des revendications précédentes **caractérisé en ce que** la première inductance (L'1) est disposée sur le premier brin de la ligne de transmission (401), et la deuxième inductance (L'2) est disposée sur la première branche de dérivation (405).

4. Dispositif de filtrage selon la revendication précédente **caractérisé en ce que** la première inductance (L'1) et la deuxième inductance (L'2) sont enroulées autour de l'unique noyau magnétique de façon à réaliser un couplage avec renforcement négatif des inductances mutuelles.

5. Dispositif de filtrage selon l'une au moins des revendications 1 ou 2
**caractérisé en ce que** la première inductance (L'1) et la deuxième inductance (L'3) sont disposées sur le premier brin de la de transmission (401).

6. Dispositif de filtrage selon la revendication précédente **caractérisé en ce que** la première inductance (L'1) et la deuxième inductance (L'3) sont enroulées autour de l'unique noyau magnétique de façon à réaliser un couplage avec renforcement positif des inductances mutuelles.

7. Dispositif de filtrage selon l'une au moins des revendications précédentes **caractérisé en ce qu'**il comporte :

   - une deuxième capacité (C4), en série avec une quatrième inductance (L4), disposés sur une deuxième branche de dérivation (406) reliant le premier brin de la ligne de transmission (401), au niveau du deuxième point d'entrée (503) de l'autotransformateur (501), au deuxième brin de la ligne de transmission (402);
   - une troisième capacité (C5) disposée sur une troisième branche de dérivation (406) reliant le premier brin ligne de transmission (401), au niveau du deuxième point d'entrée (503) de l'autotransformateur (501), au deuxième brin de la ligne de transmission (402).

8. Dispositif de filtrage selon la revendication précédente **caractérisé en ce que** la quatrième inductance (L4) est réalisée sous la forme d'un deuxième circuit actif (901).

9. Dispositif de filtrage selon l'une au moins des revendications précédentes **caractérisé en ce qu'**il est disposé du côté abonné (201).

10. Dispositif de filtrage selon l'une au moins des revendications précédentes **caractérisé en ce qu'**il est disposé du côté central téléphonique (202).

11. Dispositif de filtrage selon la revendication 7 et l'une au moins des revendications 1 à 4 **caractérisé en ce que** les valeurs des différents composants présents dans le dispositif de filtrage sont, avec une tolérance de 10 %, les suivantes :

   L'1= 40.5 mH
   L'2= 15.4 mH
   L"2= 9.8 mH
   L4= 1.15 mH
   C2= 68 nF
   C4= 33 nF
   C5= 1 nF

12. Dispositif de filtrage selon la revendication 7 et l'une au moins des revendications 1 à 2 ou 5 à 6 **caractérisé en ce que** les valeurs des différents composants présents dans le dispositif de filtrage sont, avec une tolérance de 10 %, les suivantes :

   L'1= 5.97 mH
   L'2= 15.4 mH
   L"2= 9.8 mH
   L4= 1.15 mH
   C2= 68 nF
   C4= 33 nF
   C5= 1 nF

13. Forme équilibrée du dispositif de filtrage selon l'une au moins des revendications précédentes.

**Claims**

1. A low-pass filtering device placed on a telephone transmission line (L), composed of a first wire (401) and a second wire (402), capable of allowing the simultaneous circulation, between a telephone exchange (202) and a subscriber (201) equipped with at least one telephone, first signals, corresponding to analogical and/or digital narrow band services, and second signals, corresponding to broadband services, **characterized in that** an unbalanced shape of the filtering device (500) comprises:

   - an autotransformer (501), constituted of a first inductance (L'1) winding and a second inductance (L'2; L'3) winding, coiled around a single magnetic core, placed between a first input point (502) on the first transmission line wire (401), a second input point (503) on the first transmission line wire (401), and a third input point (504) on a first bypass branch (405) linking the first wire (401) and the second wire (402);
- a first capacity (C2) placed in series with a third inductance (L"2) on the first bypass branch (405), the third inductance (L"2) having a value at least sufficient to compensate a negative inductance induced by the autotransformer (501) inside the first bypass branch (405).

2. A filtering device according to the previous claim, **characterized in that** the third inductance (L"2) is achieved in the form of a first active circuit (800).

3. A filtering device according to at least one of the previous claims, **characterized in that** the first inductance (L'1) is placed on the first transmission line wire (401) and that the second inductance (L'2) is placed on the first bypass branch (405).

4. A filtering device according to the previous claim, **characterized in that** the first inductance (L'1) and the second inductance (L'2) are coiled around the unique magnetic core in order to achieve a coupling with a negative reinforcement of the mutual inductances.

5. A filtering device according to at least one of the claims 1 or 2, **characterized in that** the first inductance (L'1) and the second inductance (L'3) are placed on the first bypass branch of the transmission (401).

6. A filtering device according to the previous claim, **characterized in that** the first inductance (L'1) and the second inductance (L'3) are coiled around the unique magnetic core in order to achieve a coupling with a positive reinforcement of the mutual inductances.

7. A filtering device according to at least one of the previous claims, **characterized in that** it comprises:

- a second capacity (C4), in series with a fourth inductance (L4), placed on a second bypass branch (406) linking the first transmission line wire (401), at the level of the second input point (503) of the autotransformer (501), to the second transmission line wire (402);
- a third capacity (C5) placed on a third bypass branch (406) linking the first transmission line wire (401), at the level of the second input point (503) of the autotransformer (501), to the second transmission line wire (402).

8. A filtering device according to the previous claim, **characterized in that** the fourth inductance (L4) is achieved in the form of a second active circuit (901).

9. A filtering device according to at least one of the previous claims, **characterized in that** it is placed on the side of the subscriber (201).

10. A filtering device according to at least one of the previous claims, **characterized in that** it is placed on the side of the telephone exchange (202).

11. A filtering device according to claim 7 and to at least one of the claims 1 to 4, **characterized in that** the values of the various components existing inside the filtering device are, with a 10% tolerance, the following:

L'1= 40.5 mH
L'2= 15.4 mH
L"2= 9.8 mH
L4= 1.15 mH
C2= 68 nF
C4= 33 nF
C5=1 nF

12. A filtering device according to claim 7 and to at least one of the claims 1 to 2 or 5 to 6, **characterized in that** the values of the various components existing inside the filtering device are, with a 10% tolerance, the following:

L'1= 5.97 mH
L'2= 15.4mH
L"2= 9.8 mH
L4= 1.15 mH
C2= 68 nF
C4= 33 nF
C5= 1 nF

13. A balanced form of the filtering device according to at least one of the previous claims.

**Patentansprüche**

1. Vorrichtung zur Niederpassfilterung in einer Telefonübertragungsleitung (L), bestehend aus einem ersten Strang (401) und einem zweiten Strang (402), die imstande ist, zwischen einer Telefonzentrale (202) und einem Abonnenten (201), der zumindest ein Telefon besitzt, gleichzeitig erste Signale entsprechend analogen und/ oder digitalen Schmalbandangeboten und zweite Signale entsprechend einem Breitbandangebot zu übertragen, **dadurch gekennzeichnet, dass** eine unausgeglichene Form der Filtervorrichtung (500) folgendes enthält:

- einen Autotransformator (501), bestehend aus einer Spule einer ersten Induktivität (L'1) und einer Spule einer zweiten Induktivität (L'2; L'3), die um einen einzigen Magnetkern gewickelt sind, der zwischen einem ersten Eingangspunkt (502) auf dem ersten Strang der Übertragungsleitung (401), einem zweiten Eingangspunkt (503) auf dem ersten Strang der Übertragungsleitung (401) und einem dritten Eingangspunkt (504) auf einem ersten Leitungsast (405) angelegt ist, der den ersten Strang (401) mit dem zweiten Strang (402) verbindet;

- eine erste Kapazität (C2), die auf dem ersten Leitungsast (405) mit einer dritten Induktivität (L"2) in Reihe geschaltet ist, wobei die dritte Induktivität (L"2) einen Wert aufweist, der zumindest ausreichend ist, um eine negative Induktivität, die vom Autotransformator (501) im ersten Leitungsast (405) induziert wird, auszugleichen.

2.  Filtervorrichtung nach dem vorherigen Anspruch, **dadurch gekennzeichnet, dass** die dritte Induktivität (L"2) in Form eines ersten aktiven Kreises (800) ausgeführt ist.

3.  Filtervorrichtung nach zumindest einem der vorherigen Ansprüche, **dadurch gekennzeichnet, dass** die erste Induktivität (L'1) auf dem ersten Strang der Übertragungsleitung (401), und die zweite Induktivität (L'2) auf dem ersten Leitungsast (405) angeordnet sind.

4.  Filtervorrichtung nach dem vorherigen Anspruch, **dadurch gekennzeichnet, dass** die erste Induktivität (L'1) und die zweite Induktivität (L'2) so um einen einzigen Magnetkern gewickelt sind, dass eine Kopplung mit negativer Verstärkung der gegenseitigen Induktivitäten entsteht.

5.  Filtervorrichtung nach zumindest einem der Ansprüche 1 oder 2, **dadurch gekennzeichnet, dass** die erste Induktivität (L'1) und die zweite Induktivität (L'3) auf dem ersten Strang der Übertragungsleitung (401) angeordnet sind.

6.  Filtervorrichtung nach dem vorherigen Anspruch, **dadurch gekennzeichnet, dass** die erste Induktivität (L'1) und die zweite Induktivität (L'3) so um einen einzigen Magnetkern gewickelt sind, dass eine Kopplung mit positiver Verstärkung der gegenseitigen Induktivitäten entsteht.

7.  Filtervorrichtung nach zumindest einem der vorherigen Ansprüche, **dadurch gekennzeichnet, dass** sie folgendes enthält:

- eine zweite Kapazität (C4) in Reihe mit einer vierten Induktivität (L'4), die auf einem zweiten Leitungsast (406) angeordnet sind, der den ersten Strang der Übertragungsleitung (401) im Bereich des zweiten Eingangspunktes (503) des Autotransformators (501) mit dem zweiten Strang der Übertragungsleitung (402) verbindet.

8.  Filtervorrichtung nach dem vorherigen Anspruch, **dadurch gekennzeichnet, dass** die vierte Induktivität (L4) in Form eines zweiten aktiven Kreises (901) ausgeführt ist.

9.  Filtervorrichtung nach zumindest einem der vorherigen Ansprüche, **dadurch gekennzeichnet, dass** sie auf Seiten des Abonnenten (201) angeordnet ist.

10.  Filtervorrichtung nach zumindest einem der vorherigen Ansprüche, **dadurch gekennzeichnet, dass** sie auf Seiten der Telefonzentrale (202) angeordnet ist.

11.  Filtervorrichtung nach Anspruch 7 und zumindest einem der Ansprüche 1 bis 4, **dadurch gekennzeichnet, dass** die verschiedenen Bauteile, die in der Filtervorrichtung enthalten sind, folgende Werte mit einer Toleranz von 10% aufweisen:

L'1 = 40.5 mH
L'2 = 15.4 mH
L"2 = 9.8 mH
L4 = 1.15 mH
C2 = 68 nF
C4 = 33 nF
C5 = 1 nF

12.  Filtervorrichtung nach Anspruch 7 und zumindest einem der Ansprüche 1 bis 2 oder 5 bis 6, **dadurch gekennzeichnet, dass** die verschiedenen Bauteile, die in der Filtervorrichtung enthalten sind, folgende Werte mit einer Toleranz von 10% aufweisen:

L'1 = 5.97 mH
L'2 = 15.4 mH
L"2 = 9.8 mH
L4 = 1.15 mH
C2 = 68 nF
C4=33nF
C5 = 1 nF

13.  Ausgeglichene Form der Filtervorrichtung nach zumindest einer der vorherigen Ansprüche.

Spectre
de
puissance

100

103

104    105

102

107                    101

Spectre
vocal

4khz  4,2khz        4,3khz              1,1Mhz  Echelle des
                                                frequences

106              106

Fig. 1

208  207  201      202    205    206

200                                204

L

Splitter            Splitter    D
                              S
                              L
                              A
                              M    Internet

209                              203

Fig. 2

C51

L

L50

C52

**Fig. 3A**

≡

**Fig. 3B**

403    404    400

401

$L_1$    $L_3$

405    406    407

$L_2$    $L_4$    $C_5$

202 L

$C_2$    $C_4$    201

402

**Fig. 4**

$L'_1 > L'_2$    601

502    $L'_1$    503    401

600    M    $L'_2$

504    405    402

**Fig. 6A**

501    500

502    503    401

504    $C_2$    $C_4$    $C_5$    L    201

405    406    407

202    $L_2$    $L_4$

402

**Fig. 5**

$L'_1 - M > 0$    M    401

$L'_2 - M < 0$    402

**Fig. 6B**

**Fig. 7A**

**Fig. 7B**

**Fig. 8**

**Fig. 9**

**Fig. 10**